# EUROPÄISCHE PATENTANMELDUNG

(11) **EP 2 081 235 A2**
(43) Veröffentlichungstag der Anmeldung: **22.07.2009**
(21) Anmeldenummer: 08021181.6
(22) Anmeldetag: 05.12.2008
(51) Int. Cl.: H01L 31/0392, B23K 26/40

(54) **Verfahren zur Herstellung eines photovoltaischen Moduls**

(30) Priorität: 19.01.2008 DE 102008005284
(71) Anmelder: SCHOTT Solar GmbH, 63755 Alzenau (DE)
(72) Erfinder: Lechner, Peter, 85591 Vaterstetten (DE); Psyk, Walter, 81371 München (DE)
(74) Vertreter: Haft, von Puttkamer, Berngruber

(57) **Zusammenfassung**

Zur Herstellung eines photovoltaischen Moduls (1) werden zur Bildung serienverschalteter Zellen (C₁, C₂, ... Cₙ, Cₙ₊₁) die Frontelektrodenschicht (3), die Halbleiterschicht (4) und die Rückelektrodenschicht (5) durch Trennlinien (6, 7, 8) strukturiert. Die Strukturierung der Frontelektrodenschicht (3) und der Halbleiterschicht (4) erfolgt mit einem Laser (13), der eine infrarote Strahlung emittiert. Bei der Strukturierung der Halbleiterschicht (4) wird die Leistung des Lasers (13) so herabgesetzt, dass die Frontelektrodenschicht (3) nicht beschädigt wird.

## Beschreibung

Die Erfindung bezieht sich auf ein Verfahren zur Herstellung eines photovoltaischen Moduls nach dem Oberbegriff des Anspruchs 1.

Bei der Herstellung eines photovoltaischen Moduls werden auf einem transparenten, elektrisch isolierenden Substrat, beispielsweise einer Glasscheibe, drei Funktionsschichten, nämlich eine transparente Frontelektrodenschicht, eine Halbleiterdünnschicht und eine Rückelektrodenschicht großflächig abgeschieden.

Um aus diesen monolithischen Schichten serienverschaltete Zellen zu bilden, werden die Schichten z. B. mit einem Laser, mechanische Verfahren oder auf chemischem Wege durch Trennlinien strukturiert.

Zur Strukturierung der Frontelektrodenschicht, die beispielsweise aus einem transparentem, elektrisch leitfähigen Metalloxid, beispielsweise Zinnoxid, besteht, wird üblicherweise die Lasertechnik verwendet. Der verwendete Laser ist typischerweise ein Neodym dotierter Yttrium-Aluminium-Granat (Nd:YAG)- oder ein Neodym dotierter Yttrium-Vanadat (Nd:YVO₄)-Festkörperlaser, der eine infrarote Strahlung mit einer Wellenlänge von 1064 nm emittiert. Bei dieser Wellenlänge weist die transparente Zinnoxid-Frontelektrodenschicht eine optische Absorption von mehreren Prozent auf.

Die Strukturierung der Halbleiterschicht, beispielsweise eine Silizium-Dünnschicht, erfolgt ebenfalls typischerweise mit Lasertechnik. Dabei wird ein frequenzverdoppelter Nd:YAG- oder Nd:YVO₄-Festkörperlaser verwendet, der damit ein Laserlicht mit einer Wellenlänge von 532 nm im sichtbaren Bereich emittiert.

Bei dieser Wellenlänge besitzt die Silizium-Dünnschicht im Vergleich zur transparenten Frontelektrodenschicht ein hohes optisches Absorptionsvermögen. Dadurch ist ein selektiver Abtrag der Halbleiterschicht ohne Beeinträchtigung der Frontelektrodenschicht möglich.

Für die Strukturierung der Rückelektrodenschicht werden mechanische Verfahren, wie die "Lift Off"-Technik, bei der auf der Halbleiterschicht in den Bereichen, an denen die Rückelektrodenschicht mit Trennlinien versehen werden soll, eine haftende Paste aufgebracht wird, mit der die Rückelektrodenschicht in diesen Bereichen durch Abziehen entfernt wird, aber auch Laserverfahren eingesetzt.

Bei der Strukturierung der Halbleiter-Dünnschicht werden mit dem Laser mit einer Wellenlänge von 532 nm die Trennlinien in der Halbleiterschicht erzeugt und dadurch die darunter liegende Frontelektrodenschicht freigelegt. Wenn dann die Rückelektrodenschicht abgeschieden wird, wird durch die Trennlinien der Halbleiterschicht die Rückelektrodenschicht mit der Frontelektrodenschicht kontaktiert, wodurch die Zellen des photovoltaischen Moduls serienverschaltet werden.

Für die Herstellung des photovoltaischen Moduls werden mehrere kostspielige Anlagen benötigt. Dabei ist die Anlage zur Halbleiterbeschichtung mit den höchsten Investitionskosten verbunden. Daneben stellt die Anlage mit dem eine Infrarotstrahlung emittierenden Laser zur Strukturierung der Frontelektrodenschicht und die weitere Anlage mit dem sichtbar Bestrahlung emittierenden Laser zur Strukturierung der Halbleiterschicht wichtige Kostenfaktoren dar.

Die Kapazität der Halbleiterbeschichtungsanlage und die Kapazität der beiden Laseranlagen sind meist unterschiedlich. Dabei wird meist eine 100%ige Auslastung der Halbleiterbeschichtungsanlage als kostspieligster Anlage angestrebt.

Wenn mit der Halbleiterbeschichtungsanlage beispielsweise eine Beschichtung von maximal 200000 Modulen pro Jahr durchgeführt werden kann, jede Laseranlage für die Frontelektrodenschicht- bzw. Halbleiterschicht-Strukturierung aber beispielsweise nur für maximal 80000 Module im Jahr eingesetzt werden kann, hat dies zur Folge, dass, weil die Kapazität von je zwei Laseranlagen mit 160000 Jahr pro Jahr nicht reicht, insgesamt sechs kostspielige Laseranlagen angeschafft werden müssen. Die Zahl der Laseranlagen führt damit bei der industriellen Herstellung von photovoltaischen Modulen zu einem erheblichen Kostenproblem.

Aufgabe der Erfindung ist es daher, die Kosten für die industrielle Herstellung photovoltaischer Module erheblich herabzusetzen.

Dies wird erfindungsgemäß dadurch erreicht, dass der Laser, der zur Strukturierung der Frontelektrodenschicht verwendet wird, auch zur Strukturierung der Halbleiterschicht eingesetzt wird.

Es hat sich nämlich gezeigt, dass man die Halbleiterschicht, beispielsweise eine Siliziumschicht, auch dann mit dem Laser entfernen kann, wenn der Laser eine Strahlung emittiert, die zwar von der transparenten Frontelektrodenschicht, nicht aber von der Halbleiterschicht absorbiert wird.

Die Absorption der Laserstrahlung durch die Frontelektrodenschicht hat nämlich zur Folge, dass sich die Frontelektrodenschicht derart aufheizt, dass die darüber liegende Halbleiterschicht thermisch entfernt und damit in der Halbleiterschicht eine Trennlinie gebildet wird.

Wesentlich ist allerdings, dass, wenn der Laser zur Strukturierung der Halbleiterschicht eingesetzt wird, seine Leistung so herabgesetzt wird, dass idealer Weise die Frontelektrodenschicht nicht beschädigt, also verletzt oder in anderer Weise beeinträchtigt wird. Dies ist möglich, weil die Frontelektrodenschicht thermisch stabiler als die Halbeiterschicht ist. Jedoch kann die Laserleistung so gesteigert werden, dass eine gezielte Beschädigung oder sonstige Änderung der Frontelektrodenschicht erfolgt, um z.B. Schwankungen von Schichteigenschaft auffangen zu können.

Das heißt, während der Laser zur Strukturierung der Frontelektrodenschicht gegebenenfalls mit seiner vollen, jedenfalls einer hohen Leistung eingesetzt wird, wird bei der Strukturierung der Halbleiterschicht eine geringere Laserleistung eingestellt, sodass zwar die Halbleiterschicht entfernt wird, die thermisch stabilere Frontelektrodenschicht jedoch erhalten bleibt.

Da erfindungsgemäß ein- und dieselbe Laseranlage sowohl zur Strukturierung der Frontelektrodenschicht wie zur Strukturierung der Halbleiterschicht einsetzbar ist, kann erfindungsgemäß die Zahl der Laseranlagen bei der industriellen Herstellung photovoltaischer Module herabgesetzt werden. Das heißt, wenn gemäß dem eingangs geschilderten Beispiel die Halbleiterbeschichtungsanlage eine maximale Kapazität für 200000 Module pro Jahr aufweist, reichen erfindungsgemäß fünf Laser mit einer maximalen Kapazität von jeweils 80000 Modulen pro Jahr aus, sodass gegenüber dem Stand der Technik eine Laseranlage eingespart werden kann.

Ebenso wird durch die Redundanz der Laserstrukturierungsprozesse nach der Erfindung eine wesentlich höhere Flexibilität und Gesamt-Anlagenverfügbarkeit in der Produktion gewährleistet. Bei Wartung oder Störung einer Laserstrukturierungsanlage (z. B. für die Frontelektrodenschicht) können aufgrund der Redundanz auch Laserstrukturierungsanlagen für die Halbleiterdünnschicht, die Prozesse für die Strukturierung der Frontelektrodenschicht übernehmen.

Die Frontelektrodenschicht kann aus einem elektrisch leitfähigem Metalloxid, beispielsweise Zinnoxid (SnO₂), insbesondere Fluor-dotiertem Zinnoxid oder einem anderen Material bestehen. Wesentlich ist nur, dass es transparent und elektrisch leitfähig ist, zumindest einen Teil, vorzugsweise 0,5 %, insbesondere mindestens 2 % der emittierten infraroten Strahlung des Lasers absorbiert und außerdem thermisch stabiler als die Halbleiterschicht ist.

Nach dem erfindungsgemäßen Verfahren werden also mit dem Laser bei hoher Leistung zunächst die Trennlinien in der auf dem transparenten Substrat, beispielsweise einer Glasscheibe, abgeschiedenen Frontelektrodenschicht zur Strukturierung der Frontelektrodenschicht erzeugt. Auf die strukturierte Frontelektrodenschicht wird anschließend beispielsweise durch Dampfabscheidung die Halbleiterschicht aufgetragen.

Die Halbleiterschicht kann aus Silizium, beispielsweise amorphem, nano-, mikro- oder polykritallinem Silizium oder einem anderen Halbleiter, beispielsweise Cadmium-Tellur bestehen.

Als Laser wird vorzugsweise ein Infrarotstrahlung emittierender Festkörperlaser verwendet, also ein Laser mit einer Wellenlänge von mindestens 800 nm, insbesondere 1000 nm und mehr. Der insbesondere im nahen Infrarotbereich emittierende Festkörperlaser kann ein Faserlaser oder ein Scheibenlaser sein.

Vorzugsweise ist der Festkörperlaser ein YAG-Laser, d. h. er weist als Wirtskristall Yttrium-Aluminium-Grant auf. Statt dessen kann der Wirtskristall auch Yttrium-Vanadat (YVO₄) sein. Zur Dotierung wird vorzugsweise Neodym verwendet, also ein Festkörperlaser mit einer Wellenlänge von 1064 nm eingesetzt. Gegebenenfalls können zur Dotierung auch Erbium, Ytterbium oder ein anderes selten Erdmetall verwendet werden. Neodym dotierte YAG-Laser (Nd: YAG-Laser) oder Neodym dotierte Yttrium-Vanadat-Laser (Nd: YVO₄-Laser) sind bevorzugt.

Zur Strukturierung der Halbleiterschicht kann der Laserstrahl durch das transparente Substrat hindurch auf die Frontelektroden- und Halbleiterschicht gerichtet werden. Statt dessen kann die Strukturierung der Halbleiterschicht auch so durchgeführt werden, dass der Laserstrahl von der anderen Seite, also direkt auf die Halbleiterschicht gerichtet wird.

Dabei kann in der Halbleiterschicht eine beispielsweise 10 bis 100 µm breite Trennlinie erzeugt werden, durch die die darüber liegende Frontelektrodenschicht freigelegt wird. Anschließend wird die Halbleiterschicht beispielsweise durch Sputtern mit der Rückelektrodenschicht beschichtet, die dann ihrerseits beispielsweise durch "Lift Off"-Technik oder ein Laserverfahren strukturiert wird. Dadurch werden aus den Funktionsschichten, also der Frontelektrodenschicht, der Halbleiterschicht und der Rückelektrodenschicht Zellen gebildet, die serienverschaltet sind. Das heißt, die Rückelektrodenschicht einer Zelle kontaktiert die Frontelektrodenschicht der benachbarten Zelle durch die Trennlinien in der Halbleiterschicht hindurch.

Die Strukturierung der Halbleiterdünnschicht kann sowohl im kontinuierlichen Betrieb des Lasers (CW-Betrieb) erfolgen oder gepulst, beispielsweise mit einem Güte-Schalter (Q-Switch-Betrieb).

Erfindungsgemäß wird die Energie des Lasers von der Frontelektrodenschicht absorbiert und durch Wärmeleitung auf die Halbleiterdünnschicht übertragen.

Bei der Laserstrahl-Einkopplung durch das transparente Substrat, in die Frontelektrodenschicht und die Halbleiterschicht zur Bildung der Trennlinien in der Halbleiterschicht dürfte die Halbleiterschicht abgesprengt, jedenfalls thermisch-mechanisch entfernt werden. Schmelzreste sind evtl. am Rand der Gräben festzustellen, die die Trennlinien in der Halbleiterschicht bilden. Die Trennlinie weist dabei je nach Betriebsart des Laser, CW- oder QS-Betrieb, wellige oder scharf begrenzte Ränder auf. Bei der Fokussierung des Laserstrahls direkt auf die Halbleiterschicht wird die Trennlinie auch thermisch-mechanisch erzeugt.

Bezeichnend für das erfindungsgemäße Verfahren ist, dass, wenn die Laserleistung so herabgesetzt wird, dass zwar die Halbleiterdünnschicht entfernt wird, jedoch idealer Weise keine Beschädigung der Frontelektrodenschicht erfolgt, die Halbleiterschicht an Stellen, an denen sich keine darunter liegende Frontelektrodenschicht befindet, beispielsweise bei sich kreuzenden Trennlinien in der Frontelektrodenschicht, nicht entfernt wird. Dies kann als weiterer Beweis dafür angesehen werden, dass die Absorption der Laserstrahlung durch die Frontelektrodenschicht ursächlich für die Entfernung der darüber liegenden Halbleiterschicht ist. Um jedoch z.B. Schwankungen von Schichteigenschaften auffangen zu können, kann die Laserleistung nach der Strukturierung der Halbleiterschicht so erhöht werden, so dass die Frontelektrodenschicht gezielt beschädigt wird, ohne dass die Eigenschaft der Trennlinie in der Halbleiterschicht beeinflusst wird.

Nachstehend ist die Erfindung anhand der beigefügten Zeichnung beispielhaft näher erläutert. Darin zeigen jeweils schematisch im Längsschnitt
Figur 1 ein photovoltaisches Modul; und
Figur 2a bis 2e schrittweise die Herstellung des photovoltaischen Moduls nach Figur 1.

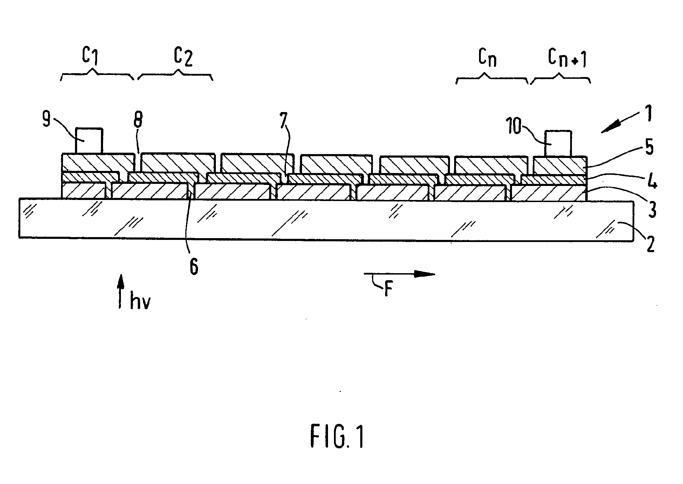

Gemäß Figur 1 weist das photovoltaische Modul 1 ein transparentes Substrat 2, beispielsweise eine Glasscheibe, auf, auf der drei Funktionsschichten, nämlich eine transparente Frontelektrodenschicht 3, eine Halbleiterdünnschicht 4 und eine Rückelektrodenschicht 5 aufeinander abgeschieden sind.

Das Modul 1 besteht aus einzelnen streifenförmigen Zellen C₁, C₂, ... Cₙ, Cₙ₊₁, die serienverschaltet sind. Dazu ist die Frontelektrodenschicht 3 durch Trennlinien 6, die Halbleiterschicht 4 durch Trennlinien 7 und die Rückelektrodenschicht 5 durch Trennlinien 8 unterbrochen, die senkrecht zur Stromflussrichtung F des Moduls 1 verlaufen.

Die Rückelektrodenschicht 5 einer Zelle C₁, ... Cₙ kontaktiert damit durch die Trennlinien 7 in der Halbleiterschicht 4 hindurch die Frontelektrodenschicht 3 der benachbarten Zelle C₂, ... Cₙ₊₁. Der von dem photovoltaischen Modul erzeugte Strom wird mit den Kontakten 9, 10 an den äußersten Zellen C₁ und Cₙ₊₁ abgenommen.

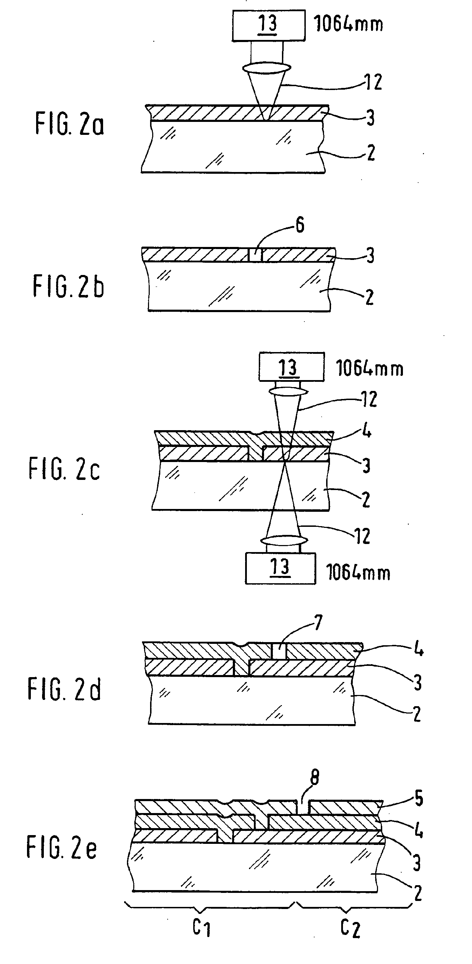

In Figur 2e ist am Beispiel der Zellen C₁ und C₂ nach Figur 1 die Serienverschaltung zweier Zellen dargestellt. Gemäß Figur 2a bis 2d werden die serienverschalteten Zellen C₁ und C₂ wie folgt hergestellt.

Aus den von einem mit der Frontelektrodenschicht 3 beschichteten Glassubstrat 2 werden mit dem fokussiertem Laserstrahl 12 eines Lasers 13, der eine Infrarotstrahlung emittiert, beispielsweise einem Nd:YAG- oder Nd:YVO₄-Laser mit einer Wellelänge von 1064 nm in der Frontelektrodenschicht 3 z. B. aus Zinnoxid die Trennlinien 6 erzeugt. Dabei wird der Laser 13 auf eine hohe Leistung eingestellt, sodass die Frontelektrodenschicht 3, die die Laserstrahlung dieser Wellenlänge absorbiert, im Bereich der Trennlinien 6 schmilzt und/oder verdampft.

In Figur 2a ist der Laserstrahl 12 direkt auf die Frontelektrodenschicht 3 gerichtet. Die Strukturierung kann jedoch auch mit einem Laserstrahl von der anderen Seite, also durch das Glassubstrat 2 hindurch, durchgeführt werden.

Auf der strukturierten Frontelektrodenschicht 3 gemäß Figur 2b wird dann die Halbleiterschicht 4, beispielsweise aus Silizium, z. B. durch chemische Dampfabscheidung abgeschieden.

Gemäß Figur 2c wird zur Strukturierung der Halbleiterschicht 4 der die gleiche Infrarotstrahlung emittierende Laser 13, also beispielsweise ein Nd:YAG- oder Nd:YVO₄-Laser mit einer Wellenlänge von 1064 nm verwendet. Dabei kann der Laserstrahl 12, in Figur 2c durch den über der Halbleiterschicht 4 angeordneten Laser 13 veranschaulicht, oder durch das Glassubstrat 2, wie in Figur 2c durch den unter dem Glassubstrat 2 angeordneten Laser 13 veranschaulicht, auf die beiden Schichten 3 und 4 in dem Bereich gerichtet werden, in dem die Trennlinien 7 zur Strukturierung der Halbleiterschicht 4 gebildet werden sollen.

Zwar absorbiert die Halbleiterschicht 4 keine bzw. sehr gering die Strahlung dieser Wellenlänge, es erfolgt jedoch überwiegend eine Absorption der Laserstrahlung 12 des Lasers 13 durch die darunter liegende Frontelektrodenschicht 3, die sich dadurch thermisch so aufheizt, dass die thermisch weniger stabile Halbleiterschicht 4 unter Bildung der Trennlinien 7 beseitigt und damit die Frontelektrodenschicht 3 in diesem Bereich freigelegt wird. Um die Frontelektrodenschicht 3 nicht zu beschädigen, wird dabei die Leistung des Lasers 13 entsprechend herabgesetzt. Jedoch kann die Laserleistung so gesteigert werden, dass eine gezielte Beschädigung der Frontelektrodenschicht 3 erfolgt, um z.B. Schwankungen von Schichteigenschaft auffangen zu können. Die Laserleistung kann somit, ohne die Eigenschaften des Trenngraben, also der Trennlinie 7, in der Halbleiterschicht 4 (Kontaktfläche für die Rückelektrode) zu beeinträchtigen, so erhöht werden, dass die Frontelektrodenschicht durch gezielte Erhöhung der Laserleistung beschädigt wird.

Anschließend wird die strukturierte Halbleiterschicht 4 (Figur 2d) z. B. durch Sputtern mit der Rückelektrodenschicht 5 beschichtet, die dann ihrerseits beispielsweise durch ein "Lift Off"-Verfahren zur Bildung der Trennlinien 8 strukturiert wird (Figur 2e).

## Patentansprüche

1. Verfahren zur Herstellung eines photovoltaischen Moduls (1), bei dem auf einem transparentem Substrat (2) eine transparente Frontelektrodenschicht (3), eine Halbleiterschicht (4) und eine Rückelektrodenschicht (5) abgeschieden wird, welche zur Bildung serienverschalteter Zellen (C₁, C₂, ... Cₙ, Cₙ₊₁) durch Trennlinien (6, 7, 8) strukturiert werden, wobei eine Laserstrukturierung der Frontelektrodenschicht (3) und der Halbleiterschicht (4) durchgeführt und zur Laserstrukturierung der Frontelektrodenschicht (3) ein Laser (13) verwendet wird, der eine infrarote Strahlung emittiert, **dadurch gekennzeichnet, dass** der Laser (13), der zur Strukturierung der Frontelektrodenschicht (3) verwendet wird, auch zur Strukturierung der Halbleiterschicht (4) eingesetzt wird, wobei die Leistung des Lasers (13) bei der Strukturierung der Halbleiterschicht (4) so herabgesetzt wird, dass die Frontelektrodenschicht (3) nicht beschädigt wird.

2. Verfahren nach Anspruch 1, **dadurch gekennzeichnet, dass** der Laser (13) eine Wellenlänge aufweist, bei der die optische Absorption der Frontelektrodenschicht (3) mindestens 0,5 % beträgt.

3. Verfahren nach Anspruch 1 oder 2, **dadurch gekennzeichnet, dass** ein Neodym dotierter Festkörperlaser mit einer Wellenlänge von 1064 nm verwendet wird.

4. Verfahren nach Anspruch 3, **dadurch gekennzeichnet, dass** ein Yttrium-Aluminium-Granat- oder ein Yttrium-Vanadat-Laser verwendet wird.

5. Verfahren nach Anspruch 3 und 4, **dadurch gekennzeichnet, dass** ein Neodym dotierter Yttrium-Aluminium-Grant-Laser oder ein Neodym dotierter Yttrium-Vanadat-Laser verwendet wird.

6. Verfahren nach einem der vorstehenden Ansprüche, **dadurch gekennzeichnet, dass** der Laserstrahl (12) zur Strukturierung der Halbleiterschicht (4) durch das transparente Substrat (2) auf die Frontelektroden- und die Halbleiterschicht (3, 4) oder direkt auf die Halbleiterschicht (4) gerichtet wird.

7. Verfahren nach Anspruch 1, **dadurch gekennzeichnet, dass** nach der Strukturierung der Halbleiterschicht (4) die Leistung des Lasers (13) erhöht wird, um die Frontelektrodenschicht (3) gezielt zu verändern, ohne die Eigenschaften der Trennlinie (7) in der Halbleiterschicht (4) zu beeinflussen.
